# EUROPÄISCHE PATENTSCHRIFT

(11) **EP 1 595 287 B1**
(45) Veröffentlichungstag und Bekanntmachung des Hinweises auf die Patenterteilung: **10.05.2006**
(21) Anmeldenummer: 04707875.3
(22) Anmeldetag: 04.02.2004
(51) Int. Cl.: H01L 23/047, H01L 23/10, H01L 23/057, H01L 23/498, H01L 21/50

(54) **ELEKTRONISCHES BAUTEIL MIT HALBLEITERCHIP UND VERFAHREN ZUR HERSTELLUNG DESSELBEN**
ELECTRONIC COMPONENT COMPRISING A SEMICONDUCTOR CHIP AND METHOD FOR PRODUCING SAID COMPONENT
COMPOSANT ELECTRONIQUE DOTE D'UNE PUCE A SEMI-CONDUCTEURS ET PROCEDE DE FABRICATION ASSOCIE

(30) Priorität: 13.02.2003 DE 10306175
(43) Veröffentlichungstag der Anmeldung: 16.11.2005
(73) Patentinhaber: Infineon Technologies AG, 81669 München (DE)
(72) Erfinder: PAULUS, Stefan, 93197 Zeitlarn (DE); PETZ, Martin, 85411 Eglhausen (DE)
(74) Vertreter: Schäfer, Horst
(86) Internationale Anmeldenummer: PCT/DE2004/000185
(87) Internationale Veröffentlichungsnummer: WO 2004/073013

(56) Entgegenhaltungen:
- EP-A- 0 094 869
- WO-A-02/09180

## Beschreibung

Die Erfindung betrifft ein elektronisches Bauteil, insbesondere ein Hochfrequenz-Leistungsmodul mit einem Hohlraumgehäuse und mit mindestens einem Halbleiterchip und mit einer Chipinsel, auf welcher der Halbleiterchip angeordnet ist.

Elektronische Bauteile, insbesondere Hochfrequenz-Leistungsmodule werden aufgrund der hohen Wärmeentwicklung und der Hochfrequenz-Eigenschaften häufig in Hohlraumgehäusen aus Keramik untergebracht. Außerdem ist es möglich, vollständig in Kunststoffmasse eingepackte Hochleistungsmodule zu bauen, deren Hochleistungshalbleiterchip auf einer Chipinsel angeordnet ist, von der mindestens eine Oberfläche eine Außenwand des Gehäuses bildet, die durch die Umgebung gekühlt werden kann. Jedoch ist der Einsatz derartiger Hochleistungsmodule für Hochfrequenz-Anwendungen aufgrund der dielektrischen Eigenschaften der Kunststoffgehäusemasse, in welche die Hochleistungshalbleiterchips eingebettet sind, begrenzt.

Aufgabe der Erfindung ist es, ein verbessertes Hohlraumgehäuse aus Kunststoff zu schaffen, das auch bei Hochtemperaturzyklen von Leistungsbauteilen nicht versagt.

Gelöst wird diese Aufgabe mit dem Gegenstand der unabhängigen Ansprüche. Vorteilhafte Weiterbildungen der Erfindung ergeben sich aus den unabhängigen Ansprüchen.

Erfindungsgemäß ist ein elektronisches Bauteil vorgesehen, das insbesondere für Hochfrequenz-Leistungsmodule geeignet ist. Dieses elektronische Bauteil weist ein Hohlraumgehäuse mit einem Gehäuserahmen auf. Der Gehäuserahmen wird aus Kunststoffwandungen gebildet, die in ihrem Fußbereich einen Metallrahmen, der eine Oberseite und eine Rückseite besitzt, aufweisen. Dieser Metallrahmen kann auch aufmetallisiert sein, wobei Mikrostrukturen zwischen Metallrahmen und dem Kunststoff der Kunststoffwandungen ausgebildet sein können. Durch geeignete Wahl von Kunststoff und Metall kann somit eine verbesserte Haftung über eine Mikrostruktur aus Ankerelementen auftreten. Auf diesen fest mit dem Gehäuserahmen aus Kunststoff verankerten Metallrahmen ist ein Gehäuseboden mit mindestens einem Halbleiterchip auf einer Chipinsel angeordnet. Dieser Gehäuseboden ist in seiner Form und Größe derart an den Metallrahmen angepasst, dass er über eine Lötfuge mit der Rückseite des Metallrahmens verbunden ist.

Ein Vorteil dieses elektronischen Bauteils ist es, dass sich bei Hochtemperaturbelastungen der metallische Gehäuseboden nicht von dem Gehäuserahmen trennt, solange die Schmelztemperatur der Lötfuge nicht überschritten wird. Die Lötbarkeit des Gehäuserahmens aufgrund des Metallrahmens im Fußbereich erleichtert auch den Zusammenbau des elektronischen Bauteils aus Gehäuserahmen mit Metallrahmen und Gehäuseboden mit Halbleiterchip. Weiterhin wird die Zuverlässigkeit und die Fertigungssicherheit erhöht, da die Funktionsprüfung des Gehäusebodens unabhängig von der Inspektion des Gehäuserahmens aus Kunststoff mit Metallrahmen im Fußbereich überprüft werden kann.

Die Zusammensetzung des Lotes in der Lötfuge richtet sich nach der Zersetzungs- oder Schmelztemperatur des Fügematerials zwischen Halbleiterchip und Chipinsel. Die Schmelz- oder Erweichungstemperatur des Lotes der Lötfuge sollte um mindestens 10°C niedriger sein als die Erweichungs-, Schmelz- oder Zersetzungstemperatur der Fügezone zwischen der Rückseite des Halbleiterchips und der Chipinsel. Damit ist der Vorteil verbunden, dass sich der auf dem Gehäuseboden beziehungsweise der Chipinsel angeordnete Halbleiterchip während des Anlötens des Gehäusebodens an den Metallrahmen im Fußbereich des Gehäuserahmens nicht mehr verschiebt.

Der nach oben offene Gehäuserahmen kann durch einen Gehäusedeckel, der in seiner Größe den Kunststoffwandungen des Gehäuserahmens angepasst ist, abgedeckt sein. Ein derartiger Gehäusedeckel kann entweder aus Kunststoff oder wie der Gehäuseboden aus einem Metall bestehen, wobei ein metallischer Gehäuseboden und ein metallische Gehäusedeckel den Vorteil einer besseren Wärmeableitung der Verlustwärme des Halbleiterchips an die Umgebung ermöglicht.

In den Kunststoffwandungen des Gehäuserahmens können Flachleiter mit ihren Mittenabschnitten verankert sein. Während Außenabschnitte der Flachleiter aus den Kunststoffwandungen herausragen, ragen Innenabschnitte der Flachleiter in den Hohlraum, den die Kunststoffwandungen bilden, hinein. Derartige Flachleiter haben den Vorteil, dass sie mit übergeordneten Schaltungen verbunden werden können. Eine Verbindung zu der Oberseite des Halbleiterchips kann durch Bondverbindungen von den Innenabschnitten der Flachleiter zu Kontaktflächen auf der Oberseite des Halbleiterchips verwirklicht sein, so dass neben einem großflächigen Außenkontakt für die Rückseite des Halbleiterchips auch äußere Flachleiteranschlüsse für die Versorgung und den Signalaustausch mit der Oberseite der Halbleiterchips zur Verfügung stehen.

Der Metallrahmen und die Ankerelemente können einstückig ausgebildet sein. Diese Einstückigkeit ist sowohl für formschlüssige Ankerelemente, die auf der Oberseite des Metallrahmens angeordnet sind und mit der Kunststoffmasse der Kunststoffwandungen formschlüssig verbunden sind, als auch für Ankerelemente, die in Art einer Mikrostruktur eine rahmenförmige Metallschicht im Fußbereich der Kunststoffwandungen aufweisen, gegeben.

In einer bevorzugten Ausführungsform der Erfindung können die Ankerelemente in die Kunststoffwandungen hineinragen und Hinterschneidungen aufweisen. Eine bevorzugte Form dieser Hinterschneidungen ist eine Schwalbenschwanzstruktur, womit formschlüssig der Metallrahmen, der eine Schwalbenschwanzstruktur trägt, mit der Kunststoffmasse der Kunststoffwandungen verbunden ist.

Auch Mikrostrukturen können derartigen Hinterschneidungen im Mikrobereich bilden, wobei Dendriten aus Metall oder Keramik in das Kunststoffgefüge der Kunststoffwandungen hineinragen und somit eine verbesserte Verbindung zwischen der Metallschicht und dem Kunststoff liefern als es eine rein adhäsive Verbindung mittels eines Klebstoffs erreichen kann.

Die Ankerelemente können auch in den Metallrahmen hineinragen, wenn der Metallrahmen zumindest in seiner Oberfläche entweder Ätzporen oder in seinem Volumen Unterätzungen aufweist. Außerdem können in den Metallrahmen auch Öffnungen eingebracht sein, deren Öffnungsquerschnitt sich zu dem Kunststoff der Kunststoffwandungen hin verringert. Beim Aufbringen der Kunststoffmasse des Gehäuserahmens kann der Kunststoff in die oberflächlichen Poren oder in die entsprechenden Öffnungen in dem Metallrahmen eindringen und somit eine formschlüssige Verbindung zwischen Metallrahmen und Kunststoffwandungen sicherstellen.

Der Gehäuserahmen kann stufenförmig von unten nach oben erweitert sein. Auf einer ersten Stufe können Innenabschnitte der Flachleiter aufliegen, die teilweise von Gehäuserahmenmaterial beziehungsweise von dem Kunststoff der Kunststoffwandungen gehalten sind. Diese Innenabschnitte können mit Nickel, Gold, Silber oder Legierungen derselben veredelte Oberflächen als Bondflächen aufweisen, so dass eine zuverlässige Bondverbindung zwischen den Innenabschnitten der Flachleiter und Kontaktflächen auf der Oberseite des Halbleiterchips möglich sind. Eine weitere Stufe kann in dem Gehäuserahmen vorgesehen sein, welche den Gehäusedeckel aufnehmen und stützen kann.

Der Fußbereich des Gehäuserahmens, der von dem Metallrahmen abgeschlossen wird, weist eine Öffnung auf, an die der Gehäuseboden des Hohlraumgehäuses angepasst ist. Der Gehäuseboden weist wegen der guten Wärmeableitung ein Metall auf, vorzugsweise aus Kupfer oder einer Kupferlegierung, das im Bereich der vorgesehenen Chipinsel mit Nickel, Gold, Silber oder Legierungen derselben veredelte Beschichtungen aufweisen kann. Der Gehäuseboden kann zusätzlich einen Metallsockel aufweisen, der aus einer metallischen Wärmesenke herausragt und in die Öffnung des Metallrahmens eingepasst ist. Durch diesen Metallsockel kann der Gehäuseboden in vorteilhafter Weise in dem Metallrahmen zentriert werden. Ferner kann eine passgenaue Lötfuge zwischen dem Metallrahmen und der metallischen Wärmesenke realisiert werden.

Der Metallsockel kann eine Höhe h aufweisen, die zusammen mit einer Dicke d des mindestens einen Halbleiterchips etwa ein Höhenniveau n erreicht, das dem Höhenniveau der Innenabschnitte der Flachleiter auf dem unteren Ansatz des Gehäuserahmens entspricht. Das hat den Vorteil, dass die Bondverbindungen zwischen Innenabschnitten der Flachleiter und Kontaktflächen der Oberseite des Halbleiterchips auf gleichem Niveau angeordnet sind. Dadurch werden geringe Bondrahtlängen ermöglicht, was die Hochfrequenzeigenschaften fördert.

Vorzugsweise werden als Halbleiterchip Hochfrequenz-Leistungshalbleiterchips in einem derartigen Gehäuse untergebracht., da die Kunststoffmasse nicht unmittelbar die Halbleiterchips berührt, sondern ein Zwischenraum zwischen dem Halbleiterchip und den Kunststoffwandungen dafür sorgt, dass die Hochfrequenz-Eigenschaften der Leistungshalbleiterchips nicht beeinträchtigt wird.

Anstelle eines einzelnen Halbleiterchips können auch mehrere Halbleiterchips auf dem Gehäuseboden zu einem Hochfrequenz-Leistungsmodul angeordnet sein. Um die Leistung zwischen den einzelnen Chips und den Flachleitern zu übertragen, können mehrere Hundert Bonddrähte parallel einen Innenabschnitt der Flachleiter mit einer Elektrode eines Halbleiterchips verbinden. Anstelle derartiger paralleler Bonddrähte können Flachbänder mit einer Dicke von 15 bis 50µm in einer Breite von mehreren Millimetern eingesetzt werden. Für das Anbringen derartiger Verbindungen bleibt zunächst das Hohlraumgehäuse nach oben hin offen, um mit den entsprechenden Werkzeugen die Bondverbindungen herzustellen.

Ein Verfahren zur Herstellung eines elektronischen Bauteils mittels eines Flachleiterrahmens weist nachfolgende Verfahrensschritte auf.

Zunächst wird ein Gehäuserahmen hergestellt. Dazu wird ein Flachleiterrahmen mit mehreren Bauteilpositionen zur Verfügung gestellt. Beim Bilden von Kunststoffwandungen in jeder der Bauteilpositionen entsteht der Gehäuserahmen unter Einbetten von Mittenabschnitten der Flachleiter des Flachleiterrahmens in das Material der Kunststoffwandungen. Gleichzeitig werden Ankerelemente eines Metallrahmens in Fußbereichen der Kunststoffwandungen eingebettet.

Alternativ kann anstelle des Einbettens eines vorgefertigten Metallrahmens mit seinen Ankerelementen in die Kunststoffmasse ein Metall im Fußbereich der Kunststoffwandungen abgeschieden werden. Um entsprechende Mikrostrukturen zwischen Metall und Kunststoff zu realisieren, die als Ankerelemente dienen können, wird entweder der Fußbereich der Kunststoffwandungen entsprechend vorbereitet, um entsprechende Poren im Kunststoff herzustellen, die dann bei einer Abscheidung einer Metallschicht als Metallrahmen im Fußbereich der Kunststoffwandungen gefüllt werden und somit eine Verankerung mit den Kunststoffwandungen ermöglicht oder indem vorher entsprechende Poren als Mikrostrukturen in die Oberseite des Metallrahmens eingebracht werden, so dass dieser über Kunststoffmikrostrukturen mit den Kunststoffwandungen verbunden ist. Das Verfahren zum Aufbringen einer formschlüssig mit der Kunststoffmasse der Kunststoffwandungen verbundenen Metallschicht wird auch MIT-Verfahren genannt.

Parallel zur Herstellung einer Vielzahl von Gehäuserahmen auf einem bandförmigen Flachleiterrahmen werden entsprechend viele metallische Gehäuseböden mit jeweils mindestens einem Halbleiterchip hergestellt. Zunächst wird dann der Halbleiterchip mit seiner Rückseite auf die Chipinsel des Gehäusebodens aufgelötet, so dass in vorteilhafter Weise ein Funktionstest für jeden Gehäuseboden mit Halbleiterchip vor seinem Anbau an einen Gehäuserahmen erfolgen kann. Damit wird auch die Ausfallrate für das zusammengebaute elektronische Bauteil vermindert, da anschließend nur funktionsfähige Gehäuseböden mit Halbleiterchip an den Metallrahmen des Gehäuserahmens durch einen Lötprozess angelötet werden.

Bei diesem Lötprozess wird vorteilhafterweise ein Lot verwendet, das bei niedrigeren Temperaturen schmilzt als eine Fügezone zwischen der Chipinsel und dem Halbleiterchip. Damit wird gewährleistet, dass sich der Halbleiterchip gegenüber der Position auf dem Gehäuseboden beim Lötprozess des Gehäusebodens an den Gehäuserahmen nicht mehr verschiebt.

Nach dem Einlöten des Gehäusebodens werden elektrische Verbindungen zwischen der Oberseite des Halbleiterchips und Innenabschnitten der Flachleiter hergestellt. Für Leistungsbauteile können mehrere Hundert Bonddrähte auf einem Innenabschnitt eines Flachleiters zu einer Kontaktfläche auf der Oberseite des Halbleiterchips gebonded werden. Anstelle von Hunderten von Bonddrähten können auch Flachbänder zwischen den Innenabschnitten der Flachleiter und den Kontaktflächen auf der Oberseite des Halbleiterchips gebonded werden. Die durch Anbringen der Gehäuseböden entstandenen Hohlraumgehäuse für elektronische Bauteile sind über den Flachleiterrahmen noch miteinander verbunden und werden in einem letzten Verfahrensschritt zu einzelnen elektronischen Bauteilen aus dem Flachleiterrahmen herausgetrennt. Dieses Heraustrennen kann durch Ausstanzen erfolgen.

Für ein Herstellen des Gehäuserahmens sind die Flachleiter des Flachleiterrahmens in einer Ebene angeordnet und in jeder der Bauteilpositionen kann ein nach unten und nach oben offener Gehäuserahmen angebracht werden, indem Mittenabschnitte der Flachleiter in den Gehäuserahmen eingebettet werden, während Außenabschnitte der Flachleiter aus dem Gehäuserahmen herausragen und Innenabschnitte der Flachleiter in einen Hohlraum des Gehäuserahmens hineinragen. Derartige Innenabschnitte der Flachleiter können beim Herstellen des Flachleiterrahmens bereits mit einer bondbaren Beschichtung versehen werden, indem ein Metall wie Nickel, Gold, Silber oder Legierungen derselben auf die Innenabschnitte der Flachleiter des Flachleiterrahmens aufgesputtert oder aufgedampft werden. Diese Verfahren haben den Vorteil, dass sie einerseits perfekte Beschichtungen liefern und andererseits für eine Massenproduktion geeignet sind.

Das Anbringen des Gehäuserahmens unter Einbetten von Mittenabschnitten der Flachleiter kann mittels Spritzgießen einer Kunststoffmasse in eine an diesen Flachleiterrahmen angepasste Spritzgussform unter Einbetten der Mittenabschnitte der Flachleiter in die Kunststoffgehäusemasse erfolgen. Gleichzeitig mit dem Einbetten der Innenabschnitte der Flachleiter können die Ankerelemente des Metallrahmens in die Kunststoffgehäusemasse in jeder Bauteilposition erfolgen, wenn ein entsprechend präparierter Metallrahmen mit aufgesetzten Ankerelementen oder mit eingeätzten Verankerungsöffnungen ausgestattet ist.

Alternativ kann der Metallrahmen durch Beschichten des fertigen Gehäuserahmens mit einem Metall erfolgen, wobei der Fußbereich der Kunststoffwandungen derart präpariert wird, dass bei einer galvanischen oder chemischen Abscheidung des Metallrahmens auf den Kunststoffwandungen gleichzeitig Mikrostrukturen entstehen, die sich eng mit der Kunststoffmasse verzahnen. Dazu werden vorzugsweise Mikroporen in die Kunststoffmasse im Fußbereich der Kunststoffwandungen eingebracht, die anschließend mit der Metallbeschichtung durch galvanische oder chemische Abscheidung aufgefüllt werden.

Zum Herstellen des Gehäusebodens wird zunächst eine Metallplatte, beispielsweise aus Kupfer oder einer Kupferlegierung, an die Öffnung des Metallrahmens angepasst. Dabei wird die Metallplatte mit einem Sockel versehen, der passgenau in die Öffnung des Metallrahmens eingebracht werden kann. Vor einem Anbau des Gehäusebodens an den Gehäuserahmen werden auf dem Sockel Chipinseln durch Aufbringen von Gold- oder Aluminiumbeschichtungen auf den Metallsockel bereitgestellt. Auf diese Chipinseln werden die Halbleiterchips mit ihren Rückseiten angebracht und anschließend kann der Gehäuseboden mit Halbleiterchips getestet werden, um sicherzustellen, dass keine Gehäuseböden eingebaut werden, die entweder falsche Halbleiterchips oder falsch ausgerichtete Halbleiterchips oder andere Defekte aufweisen.

Erst nach Aussortieren der defekten Gehäuseböden werden die funktionsfähigen Gehäuseböden mit den Halbleiterchips an den Metallrahmen der Metallwände im Fußbereich angelötet. Da der Gehäuserahmen von oben zugänglich ist, kann dann das Verbinden der Innenabschnitte der Flachleiter mit Elektroden des Halbleiterchips durchgeführt werden. Dabei wird ein Vielfach-Parallelbonden von mehreren Hundert Bonddrähten oder ein Anbringen von Flachbändern zwischen einem Innenabschnitt eines Flachleiters und einer Elektrode des Halbleiterchips oder zwischen Elektroden von mehreren Halbleiterchips durchgeführt.

Noch vor dem Versiegeln des Hohlraumgehäuses mit einem Gehäusedeckel aus Kunststoff oder Metall kann der Aufbau geprüft werden. Abschließend wird nach dem Trennen des Flachleiterrahmens in jeder der Bauteilpositionen zu einzelnen elektronischen Bauteilen dieses Bauteil Funktionstests bei extremen Temperaturzyklen zwischen beispielsweise 50°C und 150°C unterworfen, wobei sich herausgestellt hat, dass die erfindungsgemäße Anbringung eines Metallrahmens mit Lötfuge zu dem Gehäuseboden eine gesteigerte Ausbeute an funktionsfähig getesteten elektronischen Bauteilen liefert.

Die Erfindung wird nun anhand der anliegenden Figuren näher erläutert.
- Figur 1: zeigt einen schematischen Querschnitt durch ein elektronisches Bauteil mit einem Hohlraumgehäuse gemäß einer ersten Ausführungsform der Erfindung,
- Figur 2: zeigt einen schematischen Querschnitt durch einen Gehäuserahmen gemäß Figur 1,
- Figur 3: zeigt einen schematischen Querschnitt durch einen Gehäuserahmen für ein elektronisches Bauteil einer zweiten Ausführungsform der Erfindung,
- Figur 4: zeigt einen schematischen Querschnitt durch einen Gehäuserahmen für ein elektronisches Bauteil gemäß einer dritten Ausführungsform der Erfindung,
- Figur 5: zeigt eine schematische Draufsicht auf einen Ausschnitt einer Bauteilposition eines Flachleiterrahmens und einen darunter angeordneten Metallrahmen für einen Gehäuserahmen gemäß Figur 2,
- Figur 6: zeigt einen schematischen Querschnitt durch einen Flachleiterrahmen entlang der Schnittlinie A-A in Figur 5,
- Figuren 7-12: zeigen Querschnitte durch Komponenten des elektronischen Bauteils nach Durchführung einzelner Herstellungsschritte.

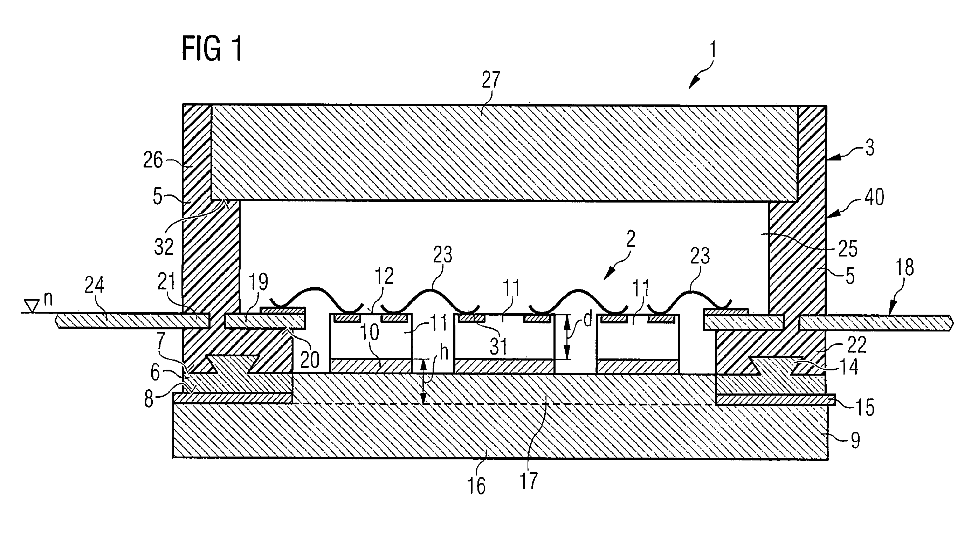

Figur 1 zeigt einen schematischen Querschnitt durch ein elektronisches Bauteil 1 mit einem Hohlraumgehäuse 3 gemäß einer ersten Ausführungsform der Erfindung. Das Hohlraumgehäuse 3 weist einen nach oben und unten offenen Gehäuserahmen 4 auf. Ein von dem Gehäuserahmen 4 umschlossener Hohlraum wird von Kunststoffwandungen 5 umgeben, wobei in einem Fußbereich der Kunststoffwandungen 5 ein Metallrahmen 6 angeordnet ist, der sich mit seiner Oberseite 7 an den Fußbereich 22 des Gehäuserahmens 4 anschließt.

Das Hohlraumgehäuse 3 wird nach unten von einem metallischen Gehäuseboden 9 abgeschlossen der in dieser Ausführungsform als Wärmesenke 16 ausgebildet ist. Der Gehäuseboden 9 ist über eine Lötfuge 15 mit der Rückseite 8 des Metallrahmens 6 verbunden. Der Metallrahmen 6 weist Ankerelemente 14 auf, die in dieser ersten Ausführungsform der Erfindung als Schwalbenschwanz ausgestaltet sind, so dass eine formschlüssige Verankerung des Metallrahmens 6 im Fußbereich 22 der Kunststoffwandungen 5 vorhanden ist.

Flachleiter 18, die gleichzeitig mit den Ankerelementen 14 in den Kunststoffwandungen 5 eingebettet sind, weisen jeweils einen Außenabschnitt 24, einen in den Kunststoff eingebetteten Mittenabschnitt 21 und einen auf einem stufenförmigen Ansatz 20 der Kunststoffwandungen 5 angeordneten Innenabschnitt 19 auf.

Auf dem Gehäuseboden 9 sind in dieser Ausführungsform der Erfindung drei Chipinseln 10 angeordnet, die aus einer Goldbeschichtung bestehen, während der Gehäuseboden 9 aus einer Kupferlegierung hergestellt ist. Mit dieser Goldbeschichtung der Chipinseln 10 bildet das Silicium der Halbleiterchips 11 beim Aufbringen unter entsprechend hohen Temperaturen eine eutektische Legierung, so dass die Halbleiterchips 11 sicher mit dem Gehäuseboden 9 verbunden sind und beim Anlöten des Gehäusebodens 9 an den Metallrahmen 6 auf den Chipinseln 10 fixiert bleiben.

Die Ankerelemente 14 sorgen dafür, dass beim Anlöten des Gehäusebodens 9 an den Metallrahmen 6 sich der Metallrahmen 6 nicht von den Kunststoffwandungen 5 löst. Auch bei hohen Temperaturbelastungen dieses Hochfrequenz-Leistungsmoduls 2 hält eine derartige formschlüssige Verankerung mit den Kunststoffwandungen 5 den Belastungen stand, so dass ein derartiges Hochfrequenz-Leistungsmodul 2 gemäß der ersten Ausführungsform eine verbesserte Lebensdauer aufweist.

Das Verbinden der Flachleiter 18 mit Kontaktflächen 31 auf aktiven Oberseiten 12 der Halbleiterchips 11 erfolgt über mehrere Hundert parallel geschaltete Bonddrähte einerseits zwischen den Innenabschnitten 19 der Flachleiter 18 und Kontaktflächen 31 und andererseits zwischen Kontaktflächen 31 der Halbleiterchips 11 untereinander. Elektrische Verbindungen 23 werden auch durch gebondete Flachleiterbänder realisiert.

Um ein Bonden auf möglichst gleichem Niveau n zu ermöglichen, weist der Gehäuseboden 9 einen Metallsockel 17 auf, der zusammen mit der Dicke der Chipinsel 10 eine Höhe h aufweist, die derart bemessen ist, dass die Dicke d der Halbleiterchips 11 plus der Höhe h des Sockels 17 das Niveau n der Flachleiter 18 erreicht. Damit lassen sich die elektrischen Verbindungen 23 in einer einzigen Bondebene durchführen.

Das elektronische Bauteil 1 mit dem Hochfrequenz-Leistungsmodul 2 im Hohlraum 25 ist durch einen Gehäusedeckel 27 nach oben abgeschlossen, der in dieser Ausführungsform der Erfindung aus einer Kupfer- oder Nickellegierung ausgebildet ist und mit einem zweiten Ansatz des Gehäuserahmens 40 in Eingriff steht. Durch die metallische Ausführung sowohl des Gehäusebodens 9 als auch des Gehäusedeckels 27 wird das Hochfrequenz-Leistungsmodul 2 gegen elektrische äußere Streufelder abgeschirmt.

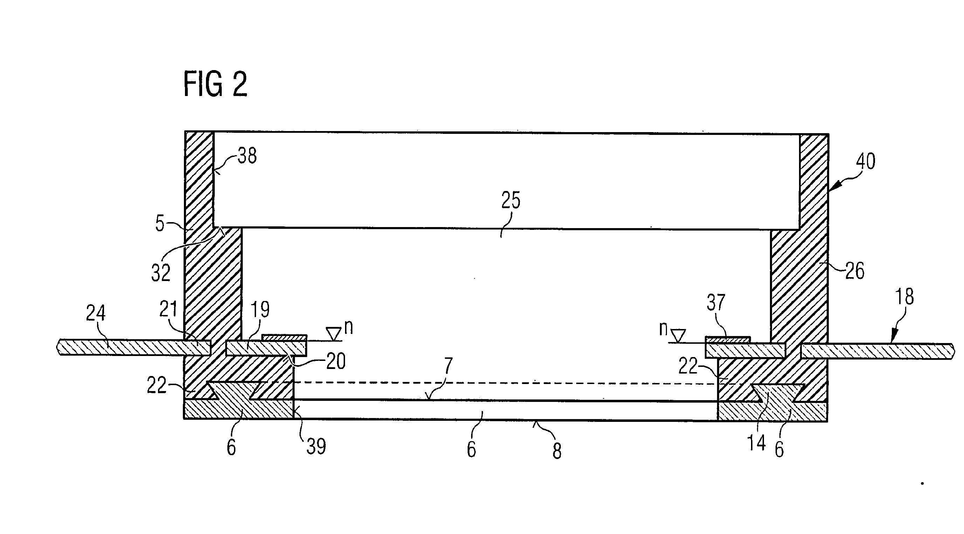

Figur 2 zeigt einen schematischen Querschnitt durch einen Gehäuserahmen 40 gemäß Figur 1. Dieser Gehäuserahmen 40 ist durch Kunststoffwandungen 5 gekennzeichnet. Der im Fußbereich 22 der Kunststoffwandungen 5 angeordnete Metallrahmen 6 ist aus einer Kupferplatte gefertigt, die im Fußbereich des Gehäuserahmens 40 eine Öffnung 39 freilässt, in die der Gehäuseboden mit seinem metallischen Sockel einpassbar ist.

Ein derartiger Gehäuserahmen 40 kann unabhängig von der Fertigung und Vorbereitung des Gehäusebodens realisiert werden, indem zunächst ein geeigneter Metallrahmen 6 aus einer Kupferplatte gefertigt wird. Das Herstellen der Hinterschneidungen kann durch Fräsen erfolgen, so dass eine sichere Verankerung beim Spritzgießen der Kunststoffwandungen 5 des Gehäuserahmens 40 erfolgt.

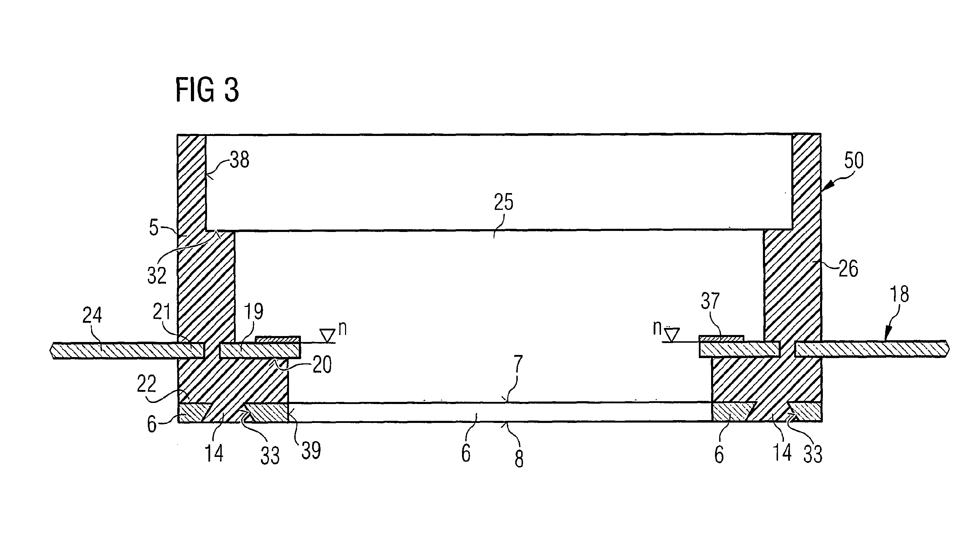

Figur 3 zeigt einen schematischen Querschnitt durch einen Gehäuserahmen 50 für ein elektronisches Bauteil einer zweiten Ausführungsform der Erfindung. In diesem Fall wird die Verankerung der Kunststoffwandungen 5 mit dem Metallrahmen 6 nicht durch Ankerelemente aus Metall erreicht, sondern durch Ankerelemente aus Kunststoff, die Teil der Kunststoffwandungen sind. Dazu können entsprechende Öffnungen 33 in den Metallrahmen 6 eingearbeitet werden bevor dieser mit Kunststoffwandungen 5 verbunden wird. Diese Öffnungen 33 weisen einen sich in Richtung auf die Kunststoffwandungen 5 sich verjüngenden Querschnitt auf, so dass eine formschlüssige Verankerung durch Auffüllen der Öffnungen 33 mit Kunststoffgehäusemasse 26 möglich ist.

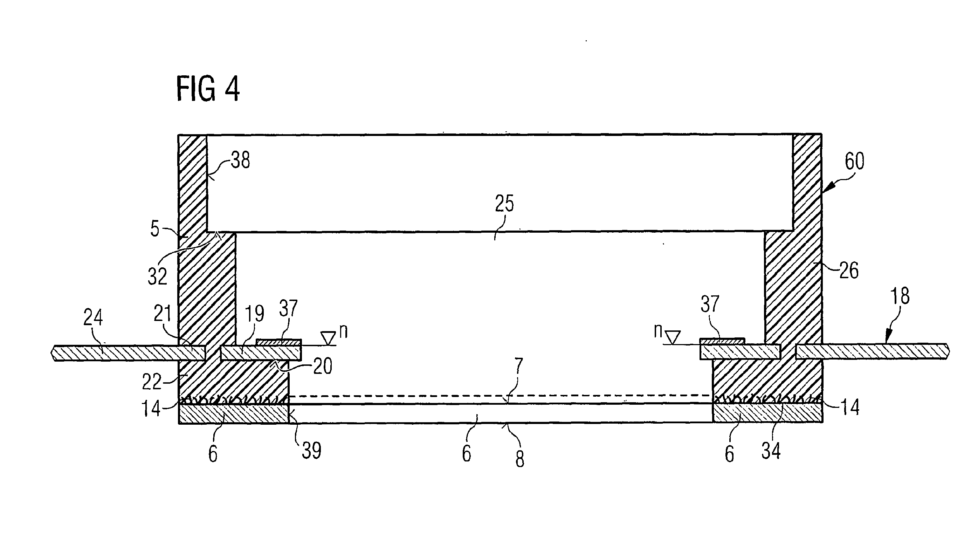

Figur 4 zeigt einen schematischen Querschnitt durch einen Gehäuserahmen 60 für ein elektronisches Bauteil gemäß einer dritten Ausführungsform der Erfindung. In dieser Ausführungsform der Erfindung wird der Metallrahmen 6 durch eine Metallbeschichtung 34 realisiert, wobei zunächst im Fußbereich 20 der Kunststoffwandungen 5 offene Poren hergestellt werden, die sich beim Abscheiden der Metallschicht zu einem Metallrahmen 6 mit metallischen Ankerelementen 14 füllen und somit eine formschlüssige Verankerung zwischen Metallbeschichtung 34 und Fußbereich 22 der Kunststoffwandungen 5 bilden. Eine hier nicht gezeigte weitere Möglichkeit besteht darin, die Oberfläche eines Metallrahmens 6 mit metallischen oder keramischen Dendriten zu versehen und dann die Kunststoffwandungen 5 aufzubringen.

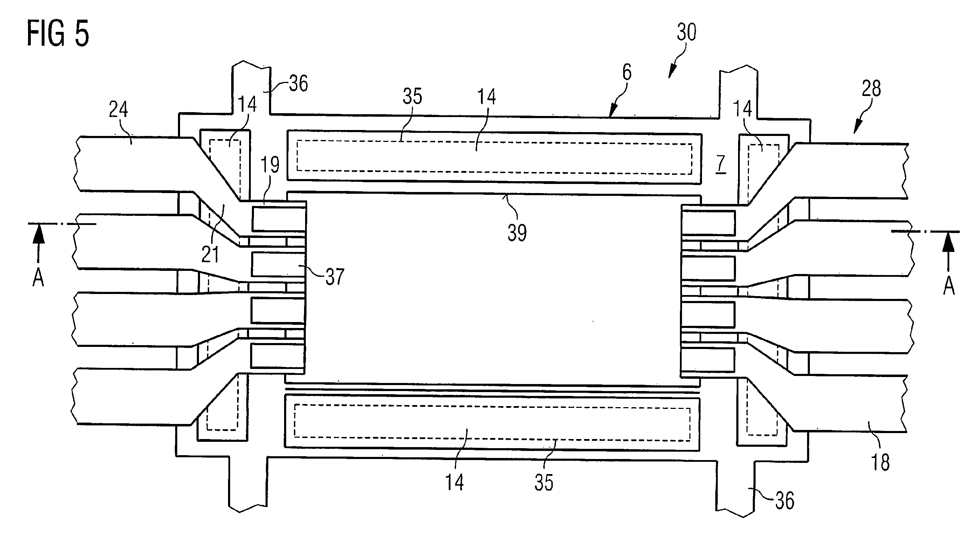

Figur 5 zeigt eine schematische Draufsicht auf einen Ausschnitt einer Bauteilposition 30 eines Flachleiterrahmens, von dem jedoch nur die Flachleiter 18 abgebildet sind. Darunter ausgerichtet ist ein Metallrahmen 6 für einen Gehäuserahmen gemäß Figur 2. Auf den vier Seiten des Metallrahmens 6 sind die schwalbenschwanzförmigen Ankerelemente 14 angeordnet, wobei Hinterschneidungen 35 durch gestrichelte Linien angedeutet werden. Ferner weist der Metallrahmen 6 dieser Ausführungsform der Erfindung vier Laschen 36 auf, die zur Fixierung und Ausrichtung des Metallrahmens 6 dienen und mit dem Flachleiterrahmen 28 verbindbar sind. Diese Laschen 36 können nach Fertigstellung des elektronischen Bauteils abgetrennt werden.

Die Innenabschnitten 19 der Flachleiter 18 sind mit Kontaktanschlussflächen 37 beschichtet. Diese Beschichtung weist ein Edelmetall, wie Gold oder Silber oder auch Aluminium auf, um ein Bonden von diesen Kontaktanschlussflächen 37 aus zu erleichtern.

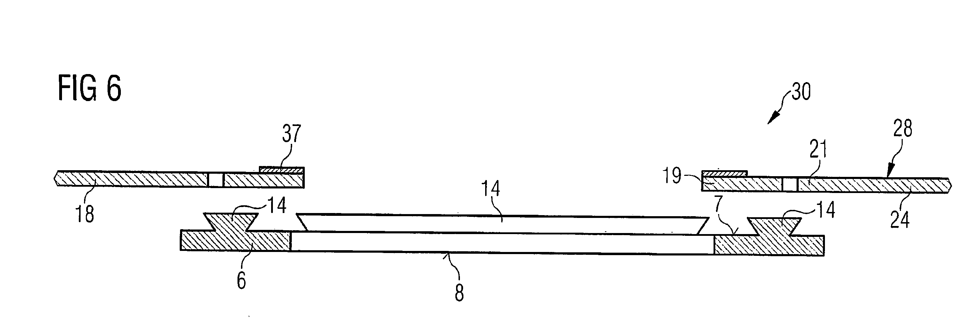

Figur 6 zeigt einen schematischen Querschnitt durch einen Flachleiterrahmen entlang der Schnittlinie A-A in Figur 5. In dieser ersten Ausführungsform der Erfindung bilden die Ankerelemente 14 und der Metallrahmen 6 eine einstückige Komponente, die unterhalb der Flachleiter 18 des Flachleiterrahmens 28 vor dem Herstellen ausgerichtet werden.

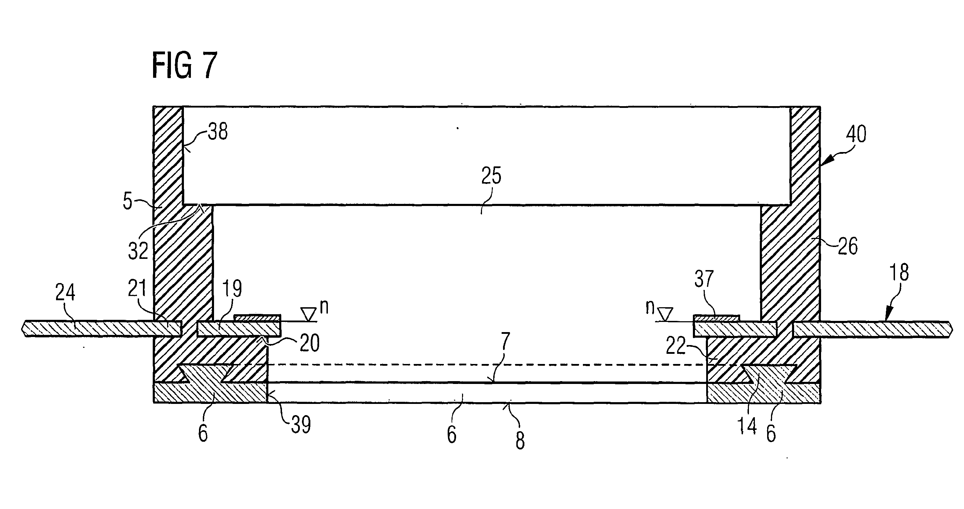

Die Figuren 7 bis 12 zeigen Querschnitte durch Komponenten des elektronischen Bauteils nach Durchführung einzelner Herstellungsschritte.

Figur 7 zeigt den fertigen Gehäuserahmen 40, wie er bereits in Figur 2 zu sehen ist. Durch Spritzgießen oder Druckgießen einer Kunststoffgehäusemasse 26 in eine Spritzgussform sind die in Figur 5 und 6 gezeigten Komponenten zu einem Gehäuserahmen 40 in einem einzigen Spritzgussvorgang miteinander verbunden. Der Hohlraum 25 des Gehäuserahmens 40 erweitert sich stufenförmig von unten nach oben, das heißt vom vorgesehenen Gehäuseboden zu dem vorgesehenen Gehäusedeckel. Auf dem ersten Absatz oder der ersten Stufe sind die in den Hohlraum 25 des Gehäuserahmens 40 hineinragenden Innenabschnitte 19 der Flachleiter 18 angeordnet, um für ein Bonden auf den Kontaktanschlussflächen 37 eine Unterstützung zu bilden. Ein zweiter stufenförmiger Ansatz 32 wird mit dem Spritzvorgang der Kunststoffwandungen 5 hergestellt, mit dem ein Gehäusedeckel in Eingriff bringbar ist.

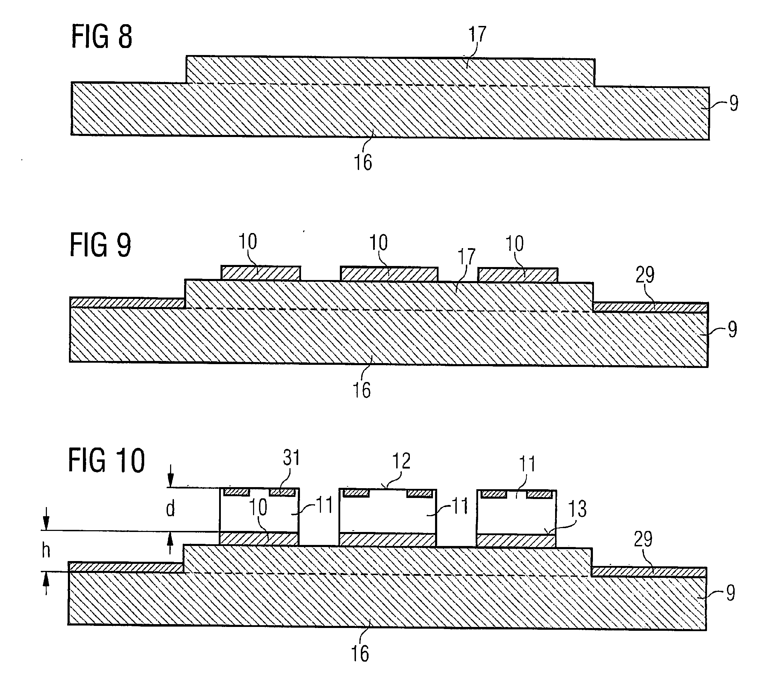

Unabhängig von der Herstellung des Gehäuserahmens 40, wie er in Figur 7 gezeigt wird, kann der metallische Gehäuseboden 9 vorbereitet und mit Halbleiterchips 11 bestückt werden. Dieses wird in den Figuren 8 bis 10 gezeigt, wobei in Figur 8 ein Querschnitt durch den Gehäuseboden 9 zu sehen ist, der einen an die Öffnung 39 des in Figur 7 gezeigten Gehäuserahmens 40 angepassten Sockel 17 aufweist. Auf den Sockel 17 sind in dieser Ausführungsform der Erfindung drei Chipinseln 10 aus einer Goldlegierung abgeschieden, die mit dem Silicium der Halbleiterchips reagiert und eine eutektische Legierung eingeht, die einen höheren Schmelzpunkt aufweist als ein Lötmaterial.

Ein derartiges Lötmaterial wird als Lotschicht 29 nach dem Aufbringen der Beschichtung für die Chipinseln 10 auf den Gehäuseboden 9 in den Bereichen aufgebracht, die mit dem Metallrahmen des in Figur 7 gezeigten Gehäuserahmens 40 durch einen Lötprozess verbunden werden sollen. Nach dem Vorbereiten eines derartigen Gehäusebodens 9, wie er in Figur 9 zu sehen ist, werden auf den Chipinseln 10 Halbleiterchips 11 bei eutektischer Temperatur auflegiert. Dieser Verbund zwischen Gehäuseboden 9 und Halbleiterchips 11 wird unabhängig von einem Funktionstest des in Figur 7 gezeigten Gehäuserahmens ebenfalls funktionsgetestet, so dass nur getestete Komponenten zu einem elektronischen Bauteil zusammengebaut werden.

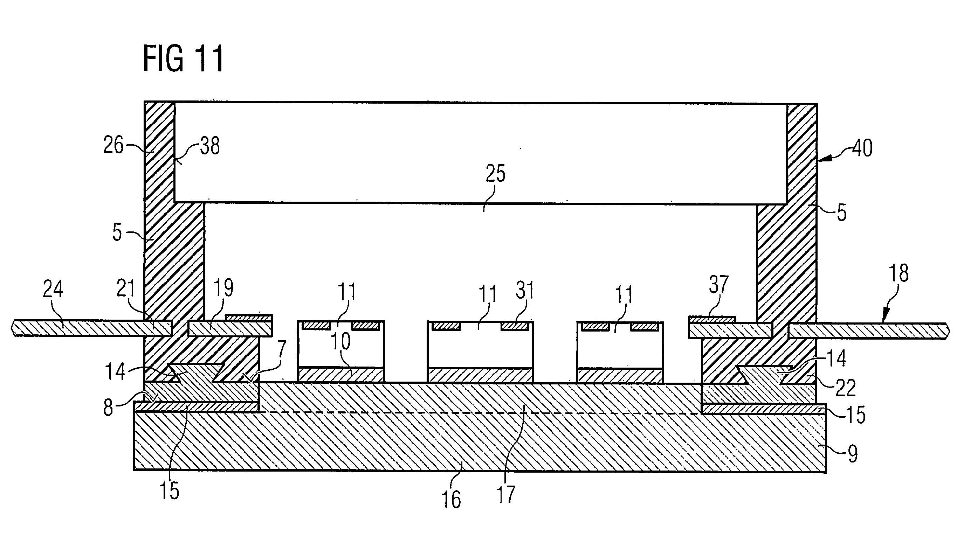

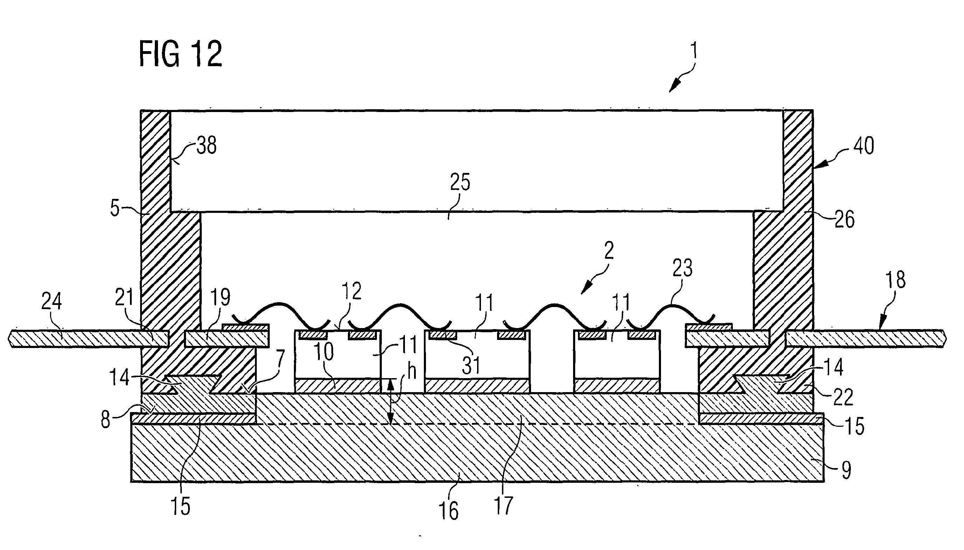

Figur 11 zeigt den Gehäuserahmen 40 nach Anlöten des Gehäusebodens 9 und Ausbilden der Lotfuge 15. Nach diesem Herstellungsschritt liegt noch kein funktionsfähiges Bauteil vor, da die elektrischen Verbindungen zwischen den Innenabschnitten 19 der Flachleiter 18 und den Kontaktflächen 31 der Halbleiterchips 11 sowie elektrische Verbindungen von Kontaktflächen der Halbleiterchips 11 untereinander fehlen. Da die Figur 11 zeigt, dass der Gehäuserahmen 40 mit angelötetem Gehäuseboden 9 nach oben hin offen ist, werden durch eine obere Öffnung 38 des Gehäuserahmens 40 die fehlenden elektrischen Verbindungen geschaffen, wie es in Figur 12 zu sehen ist.

Figur 12 zeigt ein elektronisches Bauteil 1 mit einem Hohlraumgehäuse 3, wobei in der Figur 12 im Vergleich zur Figur 1 lediglich der Gehäusedeckel noch fehlt. Dieser kann in einem letzten Schritt ergänzt werden, so dass ein elektronisches Bauelement 1, wie es Figur 1 zeigt, hergestellt ist.

## Patentansprüche

1. Elektronisches Bauteil, insbesondere Hochfrequenz-Leistungsmodul (2), das folgende Merkmale aufweist:
- ein Hohlraumgehäuse (3) mit
- einem Gehäuserahmen (40, 50, 60) mit Kunststoffwandungen (5), die in ihnem Fußbereich einen Metallrahmen (6) aufweisen, der eine Oberseite (7) und eine Rückseite (8) aufweist,
- einem metallischen Gehäuseboden (9) mit mindestens einer Chipinsel (10)
- mindestens einen Halbleiterchip (11), mit
- einer Oberseite (12) und
- einer Rückseite (13), die auf der Chipinsel (10) angeordnet ist,
wobei die Kunststoffwandungen (5) über Ankerelemente (14) mit dem Metallrahmen (6) verbunden sind und wobei der Gehäuseboden (9) über eine Lötfuge (15) mit der Rückseite (8) des Metallrahmens (6) verbunden ist.

2. Elektronisches Bauteil nach Anspruch 1,
**dadurch gekennzeichnet, dass**
der Metallrahmen (6) und die Ankerelemente (14) einstückig ausgebildet sind.

3. Elektronisches Bauteil nach Anspruch 1 oder Anspruch 2,
**dadurch gekennzeichnet, dass**
die Ankerelemente (14) in die Kunststoffwandungen (5) hineinragen und Hinterschneidungen (35) aufweisen.

4. Elektronisches Bauteil nach Anspruch 1 oder Anspruch 2,
**dadurch gekennzeichnet, dass**
die Ankerelemente (14) in den Metallrahmen (6) hineinragen.

5. Elektronisches Bauteil nach einem der vorhergehenden Ansprüche,
**dadurch gekennzeichnet, dass**
der Gehäuseboden (9) eine an den Metallrahmen (6) gelötete metallische Wärmesenke (16) aufweist.

6. Elektronisches Bauteil nach Anspruch 7,
**dadurch gekennzeichnet, dass**
der Gehäuseboden (9) einen Metallsockel (17) aufweist, der aus einer metallischen Wärmesenke (16) herausragt und in den Metallrahmen (6) eingepasst ist.

7. Elektronisches Bauteil nach Anspruch 8,
**dadurch gekennzeichnet, dass**
der Metallsockel (17) eine Höhe (h) aufweist, die zusammen mit einer Dicke (d) des Halbleiterchips (11) etwa ein Höhenniveau (n) mit Innenabschnitten (19) von Flachleitern (18), die auf einem unteren Ansatz (20) des Gehäuserahmens (9) in das Hohlraumgehäuse (3) hineinragen, bildet.

8. Verfahren zur Herstellung eines elektronischen Bauteils (1) mittels eines Flachleiterrahmens (28), das folgende Verfahrensschritte aufweist:
- Herstellen von Gehäuserahmen (40, 50, 60) auf einem Flachleiterrahmen (28) durch Bilden von Kunststoffwandungen (5) unter Einbetten von Mittenabschnitten (21) von Flachleitern (18) in den Kunststoffwandungen (5) und unter Einbetten von Ankerelementen (14) eines Metallrahmens (6) in Fußbereichen (22) der Kunststoffwandungen (5),
- Herstellen eines metallischen Gehäusebodens (9) mit mindestens einer Chipinsel (10),
- Auflöten mindestens eines Halbleiterchips (11) mit seiner Rückseite (13) auf die Chipinsel (10) des Gehäusebodens (9),
- Anbringen des Gehäusebodens (9) an den Metallrahmen (6) des Gehäuserahmens (40, 50, 60) durch einen Lötprozess,
- Herstellen von elektrischen Verbindungen (23) zwischen der Oberseite (12) des Halbleiterchips (11) und Innenabschnitten (19) der Flachleiter (18),
- Heraustrennen des elektronischen Bauteils (1) aus dem Flachleiterrahmen (28).

9. Verfahren zur Herstellung eines elektronischen Bauteils (1) mittels eines Flachleiterrahmens (28), das folgende Verfahrensschritte aufweist:
- Herstellen von Gehäuserahmen (40, 50, 60) auf einem Flachleiterrahmen (28) durch Bilden von Kunststoffwandungen (5) unter Einbetten von Mittenabschnitten (21) von Flachleitern (18) in den Kunststoffwandungen (5)
- Abscheiden eines-Metallrahmens (6) in Fußbereichen (22) des Kunststoffwandungen (5),
- Herstellen eines metallischen Gehäusebodens (9) mit mindestens einer Chipinsel (10),
- Auflöten mindestens eines Halbleiterchips (11) mit seiner Rückseite (13) auf die Chipinsel (10) des Gehäusebodens (9),
- Anbringen des Gehäusebodens (9) an den Metallrahmen (6) des Gehäuserahmens (40, 50, 60) durch einen Lötprozess,
- Herstellen von elektrischen Verbindungen (23) zwischen der Oberseite (12) des Halbleiterchips (11) und Innenabschnitten (19) der Flachleiter (18),
- Heraustrennen des elektronischen Bauteils (1) aus dem Flachleiterrahmen (28).

10. Verfahren nach Anspruch 8 oder Anspruch 9,
**dadurch gekennzeichnet, dass**
zum Herstellen des Gehäuserahmens (40, 50, 60) ein Flachleiterrahmen (28) mit einer Vielzahl von Bauteilpositionen (30) hergestellt wird, wobei in jeder der Bauteilpositionen (30) Flachleiter (18) mit freistehenden Innenabschnitten (19) in einer Ebene angeordnet sind und in jeder der Bauteilpositionen (30) ein nach unten und oben offener Gehäuserahmen (9) angebracht wird, wobei Mittenabschnitte (21) der Flachleiter (18) in den Gehäuserahmen (40, 50, 60) eingebettet werden, während Außenabschnitte (24) der Flachleiter (18) aus dem Gehäuserahmen (9) herausragen und Innenabschnitte (19) der Flachleiter (18) in einen Hohlraum (25) des Gehäuserahmens (40, 50, 60) hineinragen.

11. Verfahren nach einem der Ansprüche 8 bis 10,
**dadurch gekennzeichnet, dass**
das Anbringen des Gehäuserahmens (9) mittels Spritzgießen einer Kunststoffgehäusemasse (26) in eine an diesen Flachleiterrahmen (28) angepasste Spritzgussform unter Einbetten der Innenabschnitte (19) der Flachleiter (18) in die Kunststoffgehäusemasse (26) und unter Einbetten der Ankerelemente (14) des Metallrahmens (6) in die Kunststoffgehäusemasse (26) in jeder Bauteilposition (30) erfolgt.

## Claims

1. Electronic device, in particular a radiofrequency power module (2), which has the following features:
- a cavity housing (3) with
- a housing frame (40, 50, 60) with plastic walls (5) which have, in their foot region, a metal frame (6) having a top side (7) and a rear side (8),
- a metallic housing bottom (9) with at least one chip island (10),
- at least one semiconductor chip (11), with
- a top side (12) and
- a rear side (13) arranged on the chip island (10),
the plastic walls (5) being connected to the metal frame (6) by means of anchoring elements (14), and the housing bottom (9) being connected to the rear side (8) of the metal frame (6) by means of a soldering joint (15).

2. Electronic device according to Claim 1,
**characterized in that**
the metal frame (6) and the anchoring elements (14) are formed in one piece.

3. Electronic device according to Claim 1 or Claim 2,
**characterized in that**
the anchoring elements (14) project into the plastic walls (5) and have undercuts (35).

4. Electronic device according to Claim 1 or Claim 2,
**characterized in that**
the anchoring elements (14) project into the metal frame (6).

5. Electronic device according to one of the preceding claims,
**characterized in that**
the housing bottom (9) has a metallic heat sink (16) soldered onto the metal frame (6).

6. Electronic device according to Claim 7,
**characterized in that**
the housing bottom (9) has a metal base (17), which projects from a metallic heat sink (16) and is fitted into the metal frame (6).

7. Electronic device according to Claim 8,
**characterized in that**
the metal base (17) has a height (h), which, together with a thickness (d) of the semiconductor chip (11) approximately forms a height level (n) with inner sections (19) of flat conductors (18) which project into the cavity housing (3) on a lower attachment (20) of the housing frame (9).

8. Method for producing an electronic device (1) by means of a flat conductor frame (28), which has the following method steps:
- production of housing frames (40, 50, 60) on a flat conductor frame (28) by formation of plastic walls (5) with central sections (21) of flat conductors (18) being embedded in the plastic walls (5) and with anchoring elements (14) of a metal frame (6) being embedded in foot regions (22) of the plastic walls (5),
- production of a metallic housing bottom (9) with at least one chip island (10),
- soldering of at least one semiconductor chip (11) by its rear side (13) onto the chip island (10) of the housing bottom (9),
- fitting of the housing bottom (9) to the metal frame (6) of the housing frame (40, 50, 60) by means of a soldering process,
- production of electrical connections (23) between the top side (12) of the semiconductor chip (11) and inner sections (19) of the flat conductors (18),
- separation of the electronic device (1) out of the flat conductor frame (28).

9. Method for producing an electronic device (1) by means of a flat conductor frame (28), which has the following method steps:
- production of housing frames (40, 50, 60) on a flat conductor frame (28) by formation of plastic walls (5) with central sections (21) of flat conductors (18) being embedded in the plastic walls (5),
- deposition of a metal frame (6) in foot regions (22) of the plastic walls (5),
- production of a metallic housing bottom (9) with at least one chip island (10),
- soldering of at least one semiconductor chip (11) by its rear side (13) onto the chip island (10) of the housing bottom (9),
- fitting of the housing bottom (9) to the metal frame (6) of the housing frame (40, 50, 60) by means of a soldering process,
- production of electrical connections (23) between the top side (12) of the semiconductor chip (11) and inner sections (19) of the flat conductors (18),
- separation of the electronic device (1) out of the flat conductor frame (28).

10. Method according to Claim 8 or Claim 9,
**characterized in that**
in order to produce the housing frame (40, 50, 60), a flat conductor frame (28) with a multiplicity of device positions (30) is produced, flat conductors (18) with free-standing inner sections (19) being arranged in one plane in each of the device positions (30) and a downwardly and upwardly open housing frame (9) being fitted in each of the device positions (30), central sections (21) of the flat conductors (18) being embedded in the housing frames (40, 50, 60), while outer sections (24) of the flat conductors (18) project from the housing frame (9) and inner sections (19) of the flat conductors (18) project into a cavity (25) of the housing frame (40, 50, 60).

11. Method according to one of Claims 8 to 10,
**characterized in that**
the housing frame (9) is fitted by means of injection-moulding of a plastic housing composition (26) into an injection mould adapted to said flat conductor frame (28) with the inner sections (19) of the flat conductors (18) being embedded into the plastic housing composition (26) and with the anchoring elements (14) of the metal frame (6) being embedded into the plastic housing composition (26) in each device position (30).

## Revendications

1. Composant électronique, notamment module de puissance à haute fréquence (2), qui présente les caractéristiques suivantes :
- un boîtier à espace creux (3) comprenant
- un cadre de boîtier (40, 50, 60) muni de parois en matière plastique (5) qui, dans leur zone de base, présentent un cadre métallique (6) qui présente une face supérieure (7) et une face arrière (8),
- un fond de boîtier métallique (9) comprenant au moins un îlot de puce (10)
- au moins une puce en semiconducteur (11) comprenant
- une face supérieure (12) et
- une face arrière (13) qui est disposée sur l'îlot à puce (10),
les parois en matière plastique (5) étant reliées avec le cadre métallique (6) par des éléments d'ancrage (14) et le fond du boîtier (9) étant relié à la face arrière (8) du cadre métallique par un joint de brasage (15).

2. Composant électronique selon la revendication 1, **caractérisé en ce que** le cadre métallique (6) et les éléments d'ancrage (14) sont formés d'une seule pièce.

3. Composant électronique selon la revendication 1 ou la revendication 2, **caractérisé en ce que** les éléments d'ancrage (14) pénètrent dans les parois en matière plastique (5) et présentent des contre-dépouilles (35).

4. Composant électronique selon la revendication 1 ou la revendication 2, **caractérisé en ce que** les éléments d'ancrage (14) pénètrent dans le cadre métallique (6).

5. Composant électronique selon l'une des revendications précédentes, **caractérisé en ce que** le fond du boîtier (9) présente un dissipateur thermique (16) métallique brasé sur le cadre métallique (6).

6. Composant électronique selon la revendication 7, **caractérisé en ce que** le fond du boîtier (9) présente un socle métallique (17) qui dépasse d'un dissipateur thermique (16) et qui est adapté dans le cadre métallique (6).

7. Composant électronique selon la revendication 8, **caractérisé en ce que** le socle métallique (17) présente une hauteur (h) qui, combinée avec une épaisseur (d) de la puce en semiconducteur (11), forme approximativement un niveau de hauteur (n) avec des sections intérieures (19) de conducteurs plats (18) qui pénètrent dans le boîtier à espace creux (3) sur un talon inférieur (20) du cadre du boîtier (9).

8. Procédé de fabrication d'un composant électronique (1) au moyen d'un cadre à conducteurs plats (28) qui présente les étapes suivantes :
- fabrication de cadres de boîtier (40, 50, 60) sur un cadre à conducteurs plats (28) en formant des parois en matière plastique (5) en encastrant des sections centrales (21) de conducteurs plats (18) dans les parois en matière plastique (5) et en encastrant des éléments d'ancrage (14) d'un cadre métallique (6) dans les zones de base (22) des parois en matière plastique (5),
- fabrication d'un fond de boîtier (9) métallique comprenant au moins un îlot à puce (10),
- brasage d'au moins une puce en semiconducteur (11) avec sa face arrière (13) sur l'îlot à puce (10) du fond du boîtier (9),
- application du fond du boîtier (9) sur le cadre métallique (6) du cadre du boîtier (40, 50, 60) par un procédé de brasage,
- établissement de liaisons électriques (23) entre la face supérieure (12) de la puce en semiconducteur (11) et des sections intérieures (19) des conducteurs plats (18),
- extraction du composant électronique (1) du cadre à conducteurs plats (28).

9. Procédé de fabrication d'un composant électronique (1) au moyen d'un cadre à conducteurs plats (28) qui présente les étapes suivantes :
- fabrication de cadres de boîtier (40, 50, 60) sur un cadre à conducteurs plats (28) en formant des parois en matière plastique (5) en encastrant des sections centrales (21) de conducteurs plats (18) dans les parois en matière plastique (5)
- découpe d'un cadre métallique (6) dans la zone de base (22) des parois en matière plastique (5),
- fabrication d'un fond de boîtier (9) métallique comprenant au moins un îlot à puce (10),
- brasage d'au moins une puce en semiconducteur (11) avec sa face arrière (13) sur l'îlot à puce (10) du fond du boîtier (9),
- application du fond du boîtier (9) sur le cadre métallique (6) du cadre du boîtier (40, 50, 60) par un procédé de brasage,
- établissement de liaisons électriques (23) entre la face supérieure (12) de la puce en semiconducteur (11) et des sections intérieures (19) des conducteurs plats (18),
- extraction du composant électronique (1) du cadre à conducteurs plats (28).

10. Procédé selon la revendication 8 ou la revendication 9, **caractérisé en ce que** pour fabriquer le cadre de boîtier (40, 50, 60), on fabrique un cadre à conducteurs plats (28) comprenant une pluralité de positions de composant (30), des conducteurs plats (18) avec les sections intérieures (19) libres dans un plan étant disposés dans chacune des positions de composant (30) et un cadre de boîtier (9) ouvert en haut étant appliqué, les sections centrales (21) des conducteurs plats (18) étant encastrées dans le cadre de boîtier (40, 50, 60) alors que les sections extérieures (24) des conducteurs plats (18) dépassent hors du cadre de boîtier (9) et les sections intérieures (19) des conducteurs plats (18) pénètrent dans un espace creux (25) du cadre de boîtier (40, 50, 60).

11. Procédé selon l'une des revendications 8 à 10, **caractérisé en ce que** l'application du cadre de boîtier (9) s'effectue au moyen du moulage par injection d'une masse de boîtier en matière plastique (26) dans un moule à injection adapté à ce cadre à conducteurs plats (28) en encastrant les sections intérieures (19) des conducteurs plats (18) dans la masse de boîtier en matière plastique (26) et en encastrant les éléments d'ancrage (14) du cadre métallique (6) dans la masse de boîtier en matière plastique (26) dans chaque position de composant (30).
